# EUROPEAN PATENT APPLICATION

(11) **EP 4 718 956 A2**
(43) Date of publication of application: **01.04.2026**
(21) Application number: 25200063.3
(22) Date of filing: 04.09.2025
(51) Int. Cl.: H05K 5/00, H05K 7/20

(54) **LIQUID COOLED PROCESSING SYSTEM WITH REPLACEABLE MODULES**

(30) Priority: 26.09.2024 US 202418897640
(71) Applicant: Tesla, Inc., Austin, TX 78725 (US)
(72) Inventor: NASR, Mohamed Haitham Helmy, Austin, TX, 78725 (US); AU, Cindy, Austin, TX, 78725 (US); NGO, Tony, Austin, TX, 78725 (US); BHANDARI, Rishabh, Austin, TX, 78725 (US); GAO, Zheng, Austin, TX, 78725 (US); NABOVATI, Aydin, Austin, TX, 78725 (US); STRATHY, Esther, Austin, TX, 78725 (US)
(74) Representative: Liesegang, Eva

(57) **Abstract**

Modular processing systems are provided. In one aspect, a modular processing system includes a first electronics module including a first printed circuit board (PCB) and a first electronic component on the first PCB, a second electronics module including a second PCB and a second electronic component on the second PCB, and a cold plate arranged between the first electronics module and the second electronics module. The cold plate is configured to circulate a coolant to cool the first PCB and the second PCB. At least a portion of the cold plate is included in the first electronics module. The first electronics module is removably secured to the second electronics module.

## Description

### BACKGROUND

### Technical Field

The present disclosure relates generally to processing systems, and more specifically to processing systems with modular designs.

### Description of the Related Technology

Processing systems can include a plurality of components such as a system on chip (SOC), an application-specific integrated circuit (ASIC), etc. Such components can generate heat when in operation, such that cooling the components can improve the performance of the components and/or enable the components to operate in high temperature environment without failure. As processing systems fail, it can be desirable to provide the ability to service the processing system to increase the lifetime of the processing systems.

### SUMMARY OF CERTAIN INVENTIVE ASPECTS

In aspects, there is provided a modular processing system comprising: a first electronics module comprising a first printed circuit board (PCB) and a first electronic component on the first PCB; a second electronics module comprising a second PCB and a second electronic component on the second PCB; and a cold plate arranged between the first electronics module and the second electronics module, the cold plate configured to circulate a coolant to cool the first PCB and the second PCB, wherein at least a portion of the cold plate is included in the first electronics module, and wherein the first electronics module is removably secured to the second electronics module.

In some embodiments, the cold plate is attached to the first PCB with one or more thermal interface materials (TIMs) to form a thermal path between the cold plate and the first electronic component on the first PCB, and the second electronics module further comprises an interposer attached to the second PCB and wherein the interposer is thermally coupled to the first cold plate.

In some embodiments, the modular processing system further comprises: one or more thermal gap pads coupling the second electronics module to the cold plate, the one or more thermal gap pads configured to provide a thermal interface between the second electronic component on the second PCB and the cold plate.

In some embodiments, the interposer is in direct contact with the cold plate, and the interposer is clamped to the cold plate.

In some embodiments, the interposer defines a cutout, and a thermal path between the second electronic component on the second PCB and the cold plate via the cutout.

In some embodiments, the interposer is coupled to the cold plate via one or more gap pads, and the modular processing system further comprises: a heat spreader thermally coupled to the interposer, the heat spreader having a higher thermal conductivity than the interposer and configured to transfer heat from the second electronics component on the second PCB to the one or more gap pads.

In some embodiments, the modular processing system further comprises: a second cold plate, wherein the first electronics module includes the cold plate and the second electronics module includes the second cold plate.

In some embodiments, the cold plate includes a first port and the second cold plate includes a second port, the first port is configured to be connected to the second port to provide a coolant path for the coolant to flow from the cold plate to the second cold plate.

In some embodiments, the modular processing system further comprises: the cold plate includes a first opening and the second cold plate includes a second opening, the first PCB includes a male board-to-board connector and the second PCB includes a female board-to-board connector, and the male board-to-board connector and the female board-to-board connector are configured to provide an electrical connection between the first PCB and the second PCB.

In some embodiments, the first electronics module and the second electronics module are directly coupled to the cold plate.

In some embodiments, the cold plate comprises a first frame and a second frame configured to be attached to each other to form a coolant path through which the coolant flows.

In some embodiments, the first electronic component on the first PCB comprises a system on a chip configured to execute at least a part of computations associated with autonomous vehicle functionality, and wherein the second electronic component on the second PCB is configured to execute at least a part of computations associated with infotainment.

In other aspects, there is provided a method of replacing a module of a modular processing system, the method comprising: detaching a first electronics module from a second electronics module, wherein the first electronics module comprises a first printed circuit board (PCB) and the second electronics module comprises a second PCB, wherein the first electronics module is secured to the second electronics module prior to said detaching, and wherein the modular processing system comprises a cold plate configured to cool the first PCB and the second PCB; and attaching a new first electronics module to the second electronics module using one or more fasteners.

In some embodiments, the method further comprises: identifying that the first electronics module has failed prior to the attaching.

In some embodiments, the method further comprises: removing the modulator processing system from a vehicle prior to said detaching.

In some embodiments, the modulator processing system is installed in a vehicle prior to said detaching.

In some embodiments, the cold plate is arranged between the first electronics module and the second electronics module.

In some embodiments, the method further comprises: applying one or more gap pads to an interposer of the modulator processing system prior to said attaching.

In some embodiments, the modular processing system further includes a second cold plate, the cold plate is included in the first electronics module and the second cold plate is included in the second electronics module, and said attaching comprises mounting the first electronics module to the second electronics module.

In still other aspects, there is provided a modular processing system comprises: a first electronics module comprising a first PCB and a first electronic component on the first PCB; a second electronics module comprising a second PCB and a second electronic component on the second PCB; and a cold plate configured to circulate a coolant to cool the first PCB and the second PCB, wherein the cold plate comprises a portion of the first electronics module and a portion of the second electronics module, and wherein the first electronics module is removably attached to at least one of the second electronics module or the cold plate by one or more fasteners.

### BRIEF DESCRIPTION OF THE DRAWINGS

**FIGs. 1A** and **1B** provide schematic exploded views of a processing system.
**FIGs. 2A** and **2B** provide schematic views of a modular processing system in accordance with aspects of this disclosure.
**FIGs. 3A-3C** provide cross-sectional schematic views of the modular processing system according to difference embodiments of this disclosure.
**FIGs. 4A** and **4B** provide schematic views of another modular processing system in accordance with aspects of this disclosure.
**FIG. 5** provides a cross-sectional schematic view of the modular processing system according to an embodiment of this disclosure.
**FIGs. 6A** and **6B** provide cross-sectional schematic views of a modular processing system according to another embodiment of this disclosure.
**FIG. 7** provides a cross-sectional schematic view of yet another modular processing system in accordance with aspects of this disclosure.
**FIG. 8** provides a cross-sectional schematic view of still yet another modular processing system in accordance with aspects of this disclosure.
**FIG. 9** provides a cross-sectional schematic view of an alternative embodiment of a modular processing system compared to the modular processing system of **FIG. 8****.**
**FIG. 10** is a flow diagram of a method of replacing a module of a modular processing system in accordance with aspects of this disclosure.

### DETAILED DESCRIPTION

The following detailed description of certain embodiments presents various descriptions of specific embodiments. However, the innovations described herein can be embodied in a multitude of different ways, for example, as defined and covered by the claims. In this description, reference is made to the drawings where like reference numerals and/or terms can indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

Processing systems can include a plurality of components such as a SOC, an ASIC, etc. These components can generate heat when in operation, such that cooling the components can improve the performance of the components and/or enable the components to operate in high temperature environment without failure. These types of processing systems can enable various capabilities, including Advanced Driving Assistance System (ADAS) and self-driving vehicles, that involve relatively powerful processing. As processing systems fail, it can be desirable to provide the ability to service the processing system to increase the lifetime of the processing systems. This is becoming an increasingly relevant problem to be solved with current industry trends. In addition, it can be desirable to provide the ability to upgrade one or more individual components of a processing system.

One significant design consideration for processing systems (e.g., high performance compute systems, a multi-chip module, integrated circuit assembly, etc.) is the cooling of electronic components positioned on one or more printed circuit boards (PCBs). Electronic components may operate most efficiently within a given temperature range. Accordingly, heat generated by an electronic component may increase the temperature of the electronic component above the temperature range for most efficient operation, leading to a decrease in performance and/or shutdown of the electronic component. Cooling is typically desired to maintain the temperature of the electronic components within or closer to a desired temperature range, thereby improving performance of the processing system.

Compute systems (also referred to as "processing systems") can include two or more electronics printed circuit board assemblies (PCBAs). As used herein, a PCBA generally refers to a printed circuit board (PCB) having one or more electronic components mounted thereon. The two or more PCBAs of a processing system can be cooled via a shared cold plate. Curable or other thermal interface materials (TIMs) can be used to couple the PCBAs to the cold plate to provide a thermal path allowing excess heat generated in electronic component and/or the PCBs to flow into the cold plate. While such processing systems can provide adequate cooling to the two PCBs and the electronic components mounted thereon, one drawback to this design is that it can be expensive to replace a failed component in the processing system. For example, replacing the curable TIMs may involve the use of automated dispense equipment, which is typically not available outside of the manufacturing environment. Additionally, detaching one of the PCBs from the cold plate can expose the PCB(s) to stressors that might damage electronics thereon. Thus, replacement of any portion of the processing system at a service center may not be possible as service centers typically do not have the specialized equipment used in applying curable TIMs and/or may not be able to reduce the stressors from detaching a PCB from the cold plate.

Aspects of this disclosure relate to a modular compute system that includes two modules where either of the two modules can be separately replaced. A first electronics module includes a first PCB and a first electronic component on the first PCB. A second electronics module includes a second PCB and a second electronic component on the second PCB. The second electronics module can be stacked with and vertically overlap with the first electronics module. A cold plate can be arranged between the first electronics module and the second electronics module and can circulate a coolant to cool the first PCB and the second PCB and electronic components mounted on the first PCB and the second PCB. The cold plate can be included in the first electronics module and/or the second electronics module. The first electronics module can be removably secured to the second electronics module using one or more fasteners.

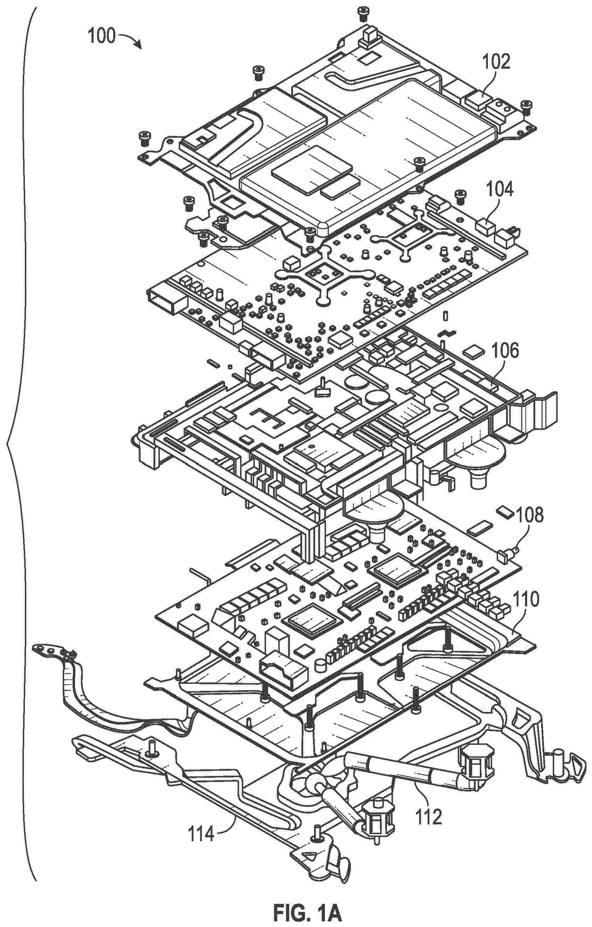

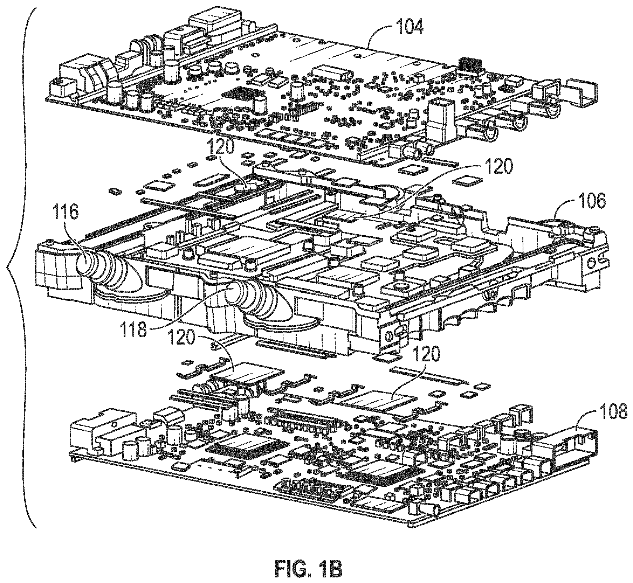

**FIGs. 1A** and **1B** provide schematic exploded views of a processing system 100. In particular, **FIG. 1A** provides a schematic exploded view of the processing system 100 while **FIG. 1B** provides a schematic exploded view of a portion of the processing system 100.

With reference to **FIGs. 1A** and **1B****,** the processing system 100 includes a first cover 102, a first PCB 104, a cold plate 106, a second PCB 108, a second cover 110, a hose assembly 112, and a mounting bracket 114. The first cover 102 is configured to cover and protect the first PCB 104 and the second cover 110 is configured to cover and protect the second PCB 108.

The cold plate 106 may be implemented as a monolithic cold plate (e.g., as a single component) that defines a coolant path between an inlet 116 and an outlet 118 of the cold plate 106. The cold plate 106 is configured to circulate a coolant through the coolant path to cool the first PCB 104 and the second PCB 108.

The hose assembly 112 is configured to provide the coolant to the inlet 116 of the cold plate 106 and receive the coolant back from the outlet 118 of the cold plate 106. The hose assembly 112 can be coupled to a heat exchanger (not illustrated) configured to cool the coolant received from the cold plate 106 before recirculating the coolant back to the cold plate 106.

The mounting bracket 114 can be directly or indirectly coupled to the first cover 102, the first PCB 104, the cold plate 106, the second PCB 108, and the second cover 110. The mounting bracket 114 provides a structure that enables the processing system 100 to be mounted in place when in use.

The processing system 100 further includes a plurality of curable TIMs 120 arranged between the cold plate 106 and each of the first PCB 104 and the second PCB 108. The curable TIMs 120 provide a relatively high thermally conductive path between electronic components formed on each of the first and second PCBs 104 and 108 and the cold plate 106. These thermal paths allow excess heat generated in the electronic components formed on the first and second PCBs 104 and 108 to flow into the cold plate 106. Curable TIMs 120 can be adhesively bonded to the cold plate 106 and the first and second PCBs 104 and 108 using automated dispense equipment.

The processing system 100 of **FIGs. 1A** and **1B** can be used for applications in which two different processing systems are desirable. For example, automotive applications can have one processing system for infotainment and another processing system for assisted and/or autonomous driving. These processing systems can generate excessive heat such that active cooling of the processing systems can improve performance. In place of using two separate processing systems, each having its own individual cooling system, the processing system 100 illustrated in **FIGs. 1A** and **1B** can be used to reduce the cost, weight, and packaging involved in providing the two processing systems.

The dispensable curable TIMs 120 are a reliable choice for automotive electronics since the plurality of curable TIMs 120 can apply minimal strain (e.g., less than a threshold strain) to the first and second PCBs 104 and 108 and the electronic components formed thereon while also provide good thermal performance (e.g., up to 10-15 W/mK). However, one drawback to the use of the curable TIMs 120 is that curable TIMs 120 are typically applied using automated dispense equipment. Without using automated dispense equipment, the curable TIMs 120 may not be applied with sufficient consistency, which can lead to insufficient cooling of the electronic components formed on the first and second PCBs 104 and 108 and ultimately may lead to failure.

In the event that one of the first and second PCBs 104 and 108 fails, it may not be possible to replace only the failed one of the first and second PCBs 104 and 108 at a service center because service centers may not be equipped with automated dispense equipment for the curable TIMs 120. In addition, service technicians may not be qualified to use of such equipment. Another risk is that service technicians may mishandle the first and second PCBs 104 and 108, respectively, leading to electronics damage. Manual replacement of a failed one of the first and second PCBs 104 and 108 at a service center may not be feasible and/or possible without automated TIM dispense equipment. It may also be messy and time consuming to clean away residue of the curable TIMs 120. Thus, even when one of the first and second PCBs 104 and 108 is still fully functional, the entire processing system 100 may be replaced.

However, due to the cost of the individual first and second PCBs 104 and 108, it can be desirable to be able to manually replace the failed one of the first and second PCBs 104 and 108 rather than replace the entire processing system 100. Aspects of this disclosure relate to a modular processing system that enables manual replacement of a failed one of the first and second PCBs 104 and 108 reliably and efficiently.

Aspects of this disclosure relate to systems and methods for enabling the individual replacement of a first electronics module or a second electronics module for a processing system including the two modules. Embodiments of this disclosure relate to a modular processing system having: i) a single cold plate with separable electronics modules, or ii) two electronics modules with two connected, independent cold plates. Further aspects of this disclosure provide an alternative process-oriented technique for reworking the adhesively bonded curable TIM to reduce both hardware cost and service cost.

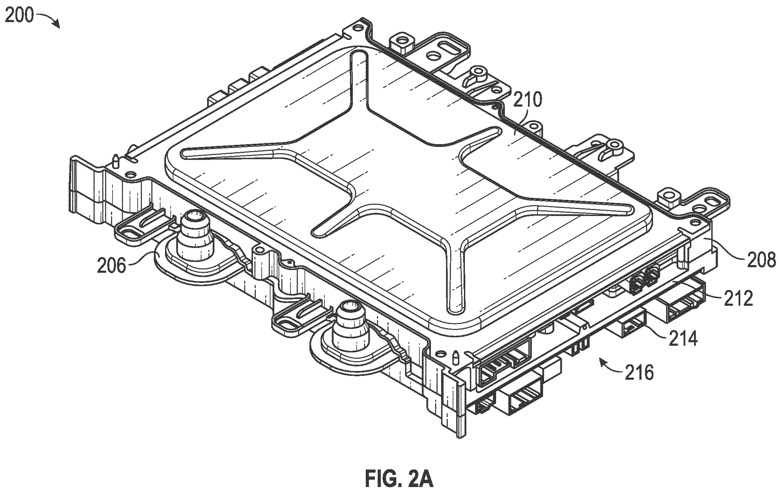

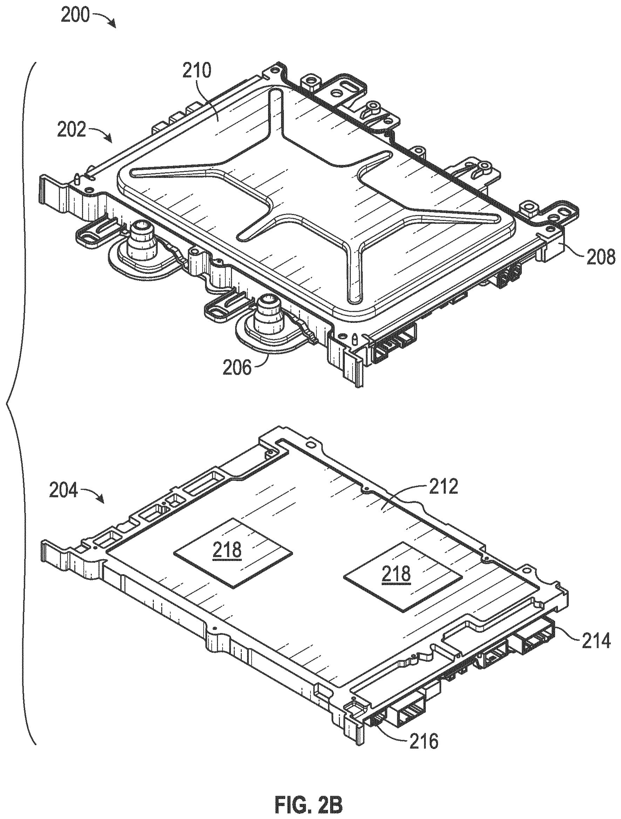

**FIGs. 2A** and **2B** provide views of a modular processing system 200 in accordance with aspects of this disclosure. In particular, **FIG. 2A** provides an isometric view of the modular processing system 200 while **FIG. 2B** provides a view the processing system 200 with the two modules separated.

With reference to **FIGs. 2A** and **2B****,** the modular processing system 200 includes a first electronics module 202 and a second electronics module 204. The first electronics module 202 includes a cold plate 206, a first PCB 208, and a first cover 210. The second electronics module 204 includes an interposer 212, a second PCB 214, and a second cover 216.

The first PCB 208 is arranged between the first cover 210 and the cold plate 206, such that the first cover 210 and the cold plate 206 can protect the first PCB 208. Similarly, the second PCB 214 is arranged between the interposer 212 and the second cover 216, such that the interposer 212 and the second cover 216 can protect the second PCB 214.

In some embodiments, the interposer 212 is configured to be removably secured to the cold plate 206 using one or more fasteners (e.g., screws, bolts, deformable eyelets, etc.) such that the first electronics module 202 can be detached from the second electronics module 204 to facilitate replacement of either of the first and second electronics modules 202 and 204. The interposer 212 is also configured to protect the second PCB 214 when the second electronics module 204 is detached from the first electronics module 202 (e.g., during replacement).

The modular processing system 200 also includes one or more gap pads 218 configured to provide a thermal path between electronic components (e.g., SOCs) formed on the second PCB 214 and the cold plate 206. The interposer 212 provides a rigid backing for the one or more gap pads 218 to allow for gap pad 218 pressure preload (e.g., during installation of the one or more gap pads 218) and to increase reliability of the electronic components of the second PCB 214. In some embodiments, the one or more gap pads 218 can be tacky and/or an adhesive layer and the one or more gap pads 218 can be pre-applied on the first or second electronics module 202 or 204 being replaced. In such embodiments, service technicians can avoid to handling the gap pads 218 and risking contamination.

In some embodiments, the first PCB 208 may have higher power electronic components compared to the second PCB 214. Thus, it may be desirable to provide more cooling for the electronic components formed on the first PCB 208 compared to the electronic components formed on the second PCB 214. To provide additional cooling, the cold plate 206 can be included within the first electronics module 202. This can reduce the distance and number of thermal layers between the electronic components formed on the first PCB 208 and cold plate 206 to provide higher levels of cooling to the electronic components formed on the first PCB 208.

In some applications, the electronic components on the first PCB 208 include higher power processors (e.g., autopilot (AP) processors) configured to execute at least a part of computations associated with driver assistance, AP driving, other autonomous vehicle functionality, and/or Advanced Driving Assistance System (ADAS) functionality of a vehicle. In some embodiments, the electronic components on the second PCB 214 include lower power processors (e.g., media control unit (MCU) processors) configured to execute at least a part of computations associated with infotainment system and/or media control of the vehicle. Higher power processors may generate more heat than lower power processors.

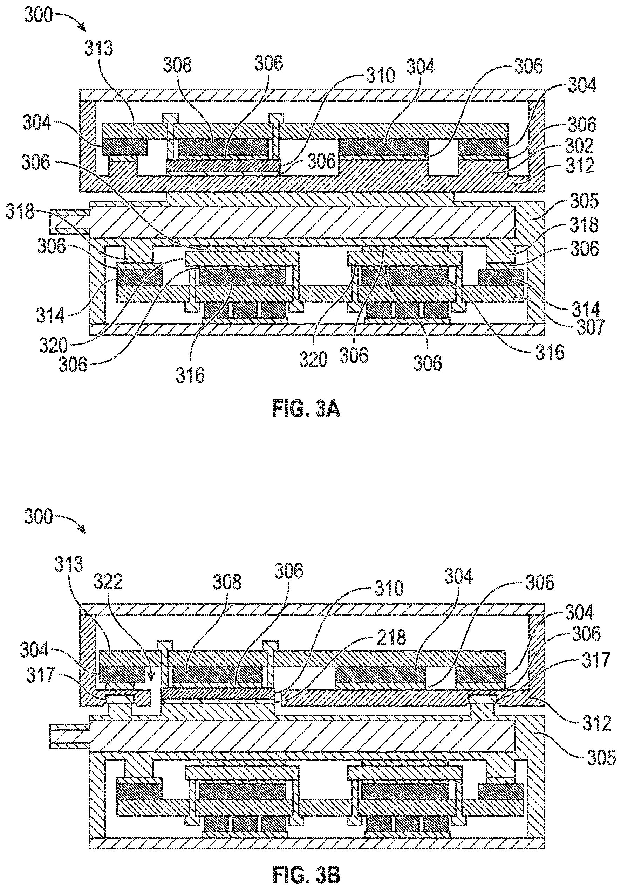

**FIGs. 3A-3C** provide cross-sectional views of a modular processing system 300 according to difference embodiments of this disclosure.

**FIG. 3A** provides a cross-sectional view of an embodiment of the modular processing system 300 in which the interposer 312 includes one or more pedestals 302. The one or more pedestals 302 can be thermally connected to one or more electronics components 304 formed on the second PCB 313 via one or more curable TIMs 306. The second PCB 313 can also include a processor 308 that may produce more heat than the one or more electronics components 304. The processor 308 can be thermally coupled to the interposer 312 via a curable TIM 306, and a floating lid 310. The floating lid 310 can include copper in certain applications.

The first PCB 307 can have one or more electronics components 314 and one or more processors 316 arranged thereon. The one or more electronics components 314 can be connected to one or more pedestals 318 on the cold plate 305 via one or more curable TIMs 306. Each of the one or more processors 316 can be coupled to the cold plate 305 via a curable TIM 306, a floating lid 320, and another curable TIM 306.

The embodiment of **FIG. 3A** can be used to simplify assembly of the modular processing system 300. For example, the interposer 312 can be in direct contact with the cold plate 305. A relatively low thermal resistance interface can be achieved without gap pads through a relatively high pressure (e.g., a pressure above a threshold value, such as 100 psi or more) contact between the interposer 312 and the cold plate 305. Since the interposer 312 and the cold plate 305 can be formed of metal, they can be made to be sufficiently stiff to be clamped with the pressure above the threshold value. The forces involved in achieving the pressure above the threshold value can be such that the electronics (e.g., the one or more electronics components 304 and/or the processor 308) are not significantly impacted since the forces can be provided by a clamp load at the interface between the interposer 312 and the cold plate 305.

**FIG. 3B** provides a cross-sectional view of an embodiment of the modular processing system 300 in which the interposer 312 has a cutout 322. Since certain components of the modular processing system 300 are similar to those of **FIG. 3A****,** not all of the similar components are provided with references numerals in **FIG. 3B****.** The discussion of these components provided in connection with **FIG. 3A** may apply to these components in **FIG. 3B****.**

The embodiment of **FIG. 3B** can provide increased levels of cooling for the processor 308 due to interposer material node being between the floating lid 310 and the cold plate 305. The floating lid 310 can be configured to function as a floating head spreader and a gap pad 317 can be directly connected to both of the floating lid 310 and the cold plate 305. This configuration can reduce the thermal resistance between the processor 308 and the cold plate 305. This can be accomplished, for example, by changing the composition of the layers and/or reducing the number of layers between the processor 308 and the cold plate 305. One or more gap pads 317 can also be provided between the interposer 312 and the cold plate 305 aligned with the one or more electronics components 304 to cool these components 304. In some other applications (not illustrated), two or more cutouts can be included in the interposer 312.

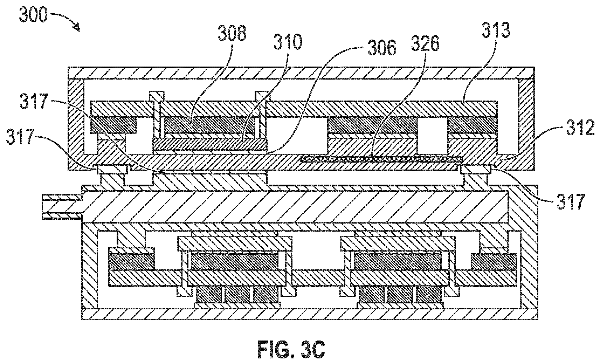

**FIG. 3C** provides a cross-sectional view of an embodiment of the modular processing system 300 in which the interposer 312 has one or more heat spreaders 326. Since certain components of the modular processing system 300 are similar to those of **FIG. 3A** and/or **3B,** not all of the similar components are provided with references numerals in **FIG. 3C****.** The discussion of these components provided in connection with **FIG. 3A** and **3B** may apply to these components in **FIG. 3C****.**

The one or more heat spreaders 326 are configured to transfer heat from local heat sources (e.g., the one or more electronics components 304) to the location(s) of the one or more gap pads 317. The one or more heat spreaders 326 can more efficiently transfer the heat than the interposer 312 alone, for example, by having a higher thermal conductivity that the interposer 312. In some embodiments, the one or more heat spreaders 326 can include conductive plates (e.g., copper plates), heat pipes, or vapor chambers. Because the one or more gap pads 317 are coupled to the cold plate 305, the heat transferred to the location(s) of the one or more gap pads 317 can be more effectively removed via the combination of the one or more heat spreaders 326 and the one or more gap pads 317. In some embodiments, the number of one or more gap pads 317 can be reduced by the proper placement of one or more heat spreaders 326, reducing the cost and reducing the pressure applied to the interposer 312.

The one or more heat spreaders 326 can include a structure that is more thermally conductive than the interposer 312. In certain embodiments, the interposer 312 can comprise aluminum (e.g., having a thermal conductivity in a range from 90 W/mK to 200 W/mK. In some embodiments, the one or more heat spreaders 326 can include a copper block (e.g., having a thermal conductivity of about 390 W/mK), a heat pipe, and/or vapor chamber(e.g., having a thermal conductivity of about 2000W/mK or greater). Embodiments of the one or more heat spreaders 326 can include: the one or more heat spreaders 326 soldered and/or press-fit into the interposer 312, the one or more heat spreaders 326 spring loaded onto a corresponding one of the one or more electronics components 304 and thermally coupled to the interposer 312 through one of the curable TIMs 306 TIM and/or a gap pad 317, the one or more heat spreaders 326 interfacing with cold plate 305 directly through a curable TIM 306 via a cutout 322 in the interposer 312 (e.g., see the cutout 322 of **FIG. 3B****),** and/or any suitable combination thereof.

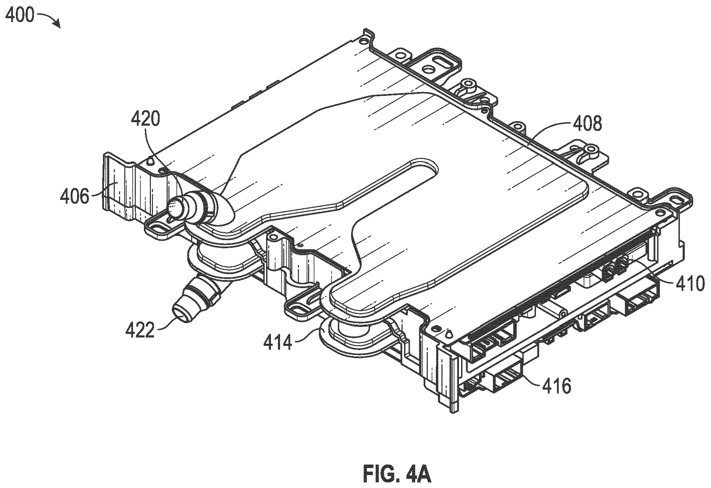

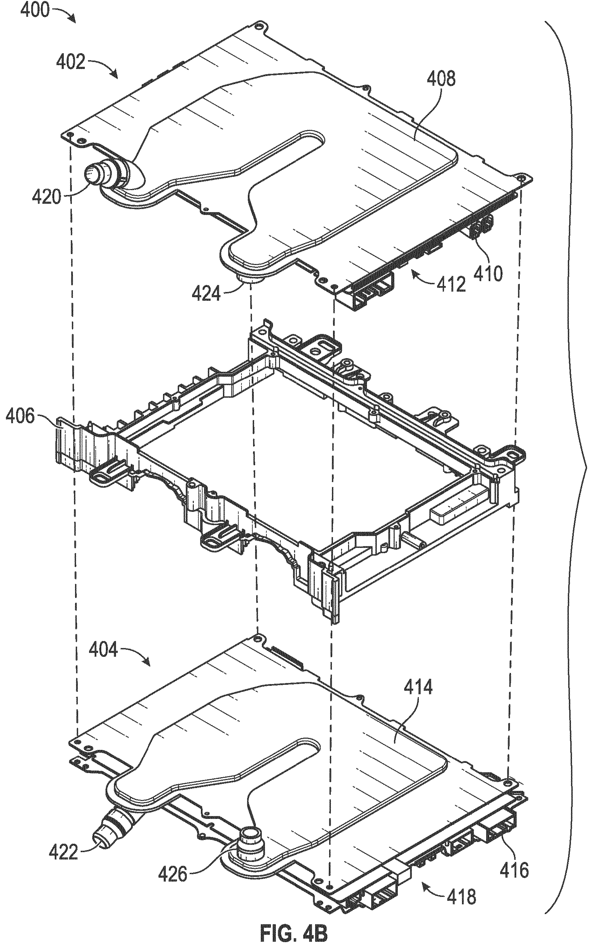

**FIGs. 4A** and **4B** provide view of another modular processing system 400 in accordance with aspects of this disclosure. In particular, **FIG. 4A** provides an isometric view of the modular processing system 400 while **FIG. 4B** provides a view the processing system 400 with the two modules separated.

With reference to **FIGs. 4A** and **4B****,** the modular processing system 400 includes a first electronics module 402, a second electronics module 404, and a frame 406. The first electronics module 402 includes a first cold plate 408, a first PCB 410, and a first cover 412. The second electronics module 404 includes a second cold plate 414, a second PCB 416, and a second cover 418. The first electronics module 402 can be removably secured to the second electronics module 404 with the frame 406 arranged therebetween using fasteners.

The first PCB 410 is arranged between the first cold plate 408 and the first cover 412, such that the first cold plate 408 and the first cover 412 can protect the first PCB 410. Similarly, the second PCB 416 is arranged between the second cold plate 414 and the second cover 418, such that the second cold plate 414 and the second cover 418 can protect the second PCB 416. As illustrated, the second cold plate 414 is positioned between the first PCB 410 and the second PCB 416.

The first cold plate 408 includes an inlet 420 configured to receive a coolant from a heat exchanger (not illustrated). The second cold plate 414 includes an outlet 422 configured to return the coolant back to the heat exchanger. The first cold plate 408 includes a first port 424 and the second cold plate 414 includes a second port 426. The first port 424 is configured to be connected to the second port 426 to form a connection that provides a coolant path for the coolant to flow from the first cold plate 408 to the second cold plate 414. The first port 424 can be sealed to the second port 426 such that coolant does not leak. In some embodiments, the first port 424 and the second port 426 are configured to form a seal upon mounting the first electronics module 402 to the second electronics module 404 (e.g., a push to seal connection).

The coolant design of the modular processing system 400 simplifies the coolant connections by allowing a single inlet 420 and a single outlet 422 to cool electronic components formed on both the first PCB 410 and the second PCB 416. For example, the coolant can flow from the first cold plate 408 to the second cold plate 414 in a series configuration.

The modular processing system 400 of **FIGs. 4A** and **4B** eliminates the need to use curable TIMs for replacement of modules, and thus, replacement of either of the first electronics module 402 or the second electronics module 404 can be performed at a service center. The modular approach to the modular processing system 400 is designed to prevent leaks via the connection at the first port 424 and second port 426with o-ring seals.

Although two modules are shown in the modular processing system 400 of **FIGs. 4A** and **4B****,** this design can be modified to have one or more additional modules stacked in series. Ports (e.g., similar to the first port 424 and the second port 426) can be provided between cold plates of each adjacent module, allowing the coolant to flow through all of the cold plates in the stack in series. Accordingly, a single inlet 420 and a single outlet 422 can be used to provide coolant to the cold plates of the entire stack. Advantageously, since the first cold plate 408 faces outward, the first PCB 410 can be protected without a separate cover piece.

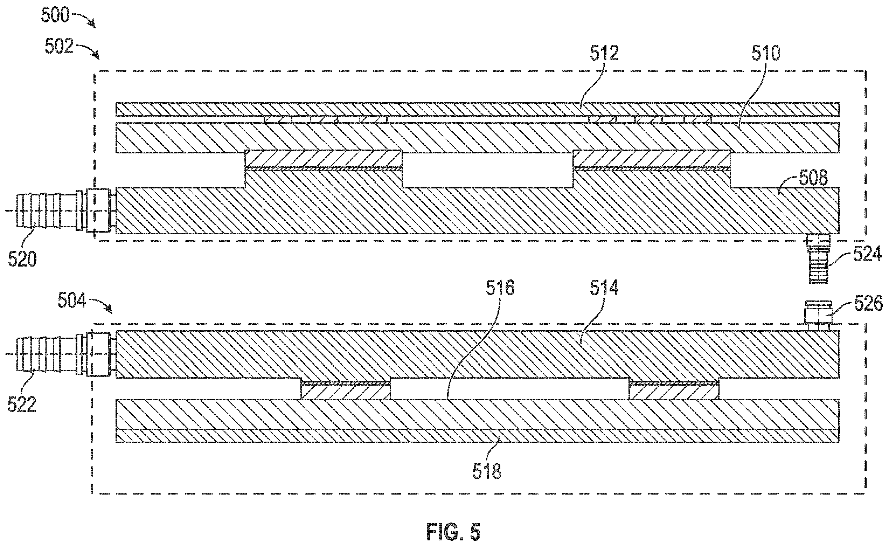

**FIG. 5** provides a cross-sectional view of a modular processing system 500 according to an embodiment of this disclosure. Similar to the modular processing system 400 of **FIG. 4****,** the modular processing system 500 of **FIG. 5** includes a first electronics module 502, a second electronics module 504, and a frame 506. The first electronics module 502 includes a first cold plate 508, a first PCB 510, and a first cover 512. The second electronics module 504 includes a second cold plate 514, a second PCB 516, and a second cover 518. The first electronics module 502 can be removably secured to the second electronics module 504 with the frame 506 arranged therebetween using fasteners.

In contrast to the modular processing system 400 of **FIG. 4****,** in the modular processing system 500 of **FIG. 5** the first cold plate 508 of the first electronics module 502 is arranged adjacent to the second cold plate 514 of the second electronics module 504. In addition, a first port 524 of the first cold plate 508 and a second port 526 of the second cold plate 514 can be located on an opposite side of the first cold plate 408 and the second cold plate 414 with respect to the single inlet 420 and the single outlet 422 compared to the modular processing system 400 of **FIG. 4****.** This arrangement enables the first cold plate 508 to be coupled to the second cold plate 514 via push to seal connection between the first port 524 and the second port 526. By arranging the first cold plate 508 and second cold plate 514 adjacent to each other as in the embodiment of **FIG. 5****,** the modular processing system 500 better isolates electronics from the fluidic connections (e.g., the first port 524 and the second port 526) such that any dripping of coolant due to a seal failure should not contact the electronics arranged on the first PCB 510 or the second PCB 516.

Although two modules are shown in the modular processing system 500 of **FIG. 5****,** this design can be modified to have one or more additional modules stacked in series. Ports (e.g., similar to the first port 524 and the second port 526) can be provided between cold plates of each adjacent module, allowing the coolant to flow through all of the cold plates in the stack in series. Accordingly, a single inlet 520 and a single outlet 522 can be used to provide coolant to the cold plates of the entire stack.

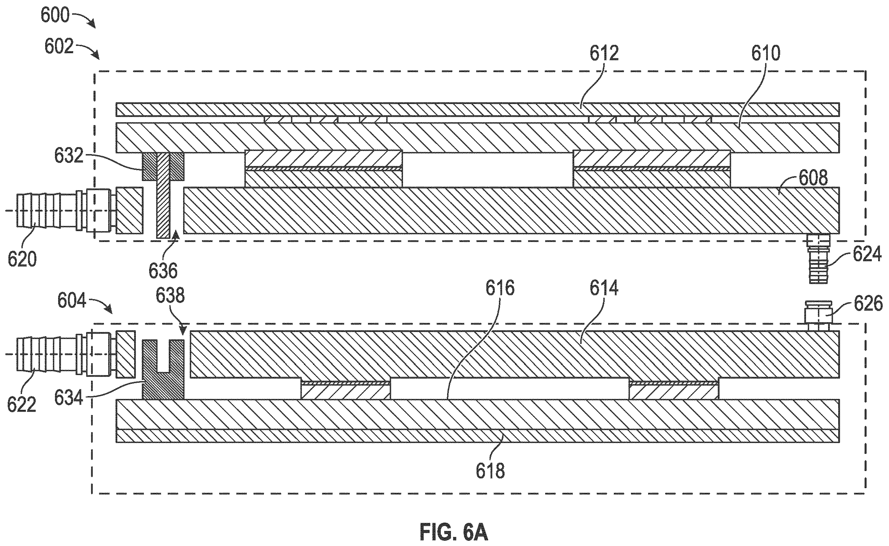

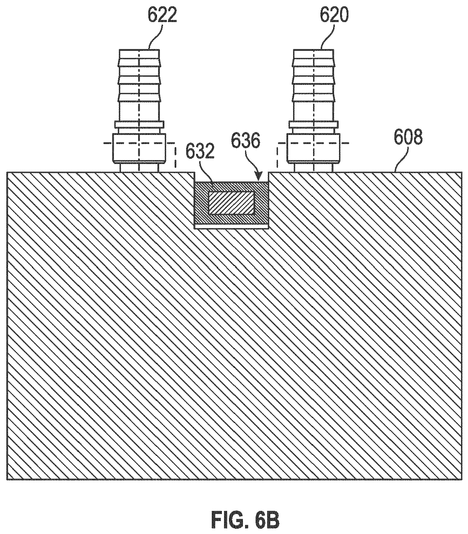

**FIGs. 6A** and **6B** provide cross-sectional views of a modular processing system 600 according to another embodiment of this disclosure. In particular, **FIG. 6A** provides a cross-sectional view from a side of the modular processing system 600 and **FIG. 6B** provides a cross-sectional view from above the modular processing system 600.

The modulator processing system 600 of **FIGs. 6A** and **6B** is like the modulator processing system 500 of **FIG. 5** and includes additional features. Similar to the modular processing system 500 of FIG. 5, the modular processing system 600 of **FIGs. 6A** and **6B** includes a first electronics module 602, a second electronics module 604, and a frame 606. The first electronics module 602 includes a first cold plate 608, a first PCB 610, and a first cover 612. The second electronics module 604 includes a second cold plate 614, a second PCB 616, and a second cover 618. The first cold plate 608 includes a first port 624 configured to be sealed to a second port 626 of the second cold plate 614, similar to the first port 524 and second port 526 of **FIG. 5****.** The first electronics module 602 can be removably secured to the second electronics module 604 with the frame 606 arranged therebetween using fasteners. In some embodiments, the fasteners can snap in place, which can help aid in alignment of the first electronics module 602 with the second electronics module 604.

As shown in **FIGs. 6A** and **6B****,** the modular processing system 600 further includes a male board-to-board connector 632 arranged on the first PCB 610 and a female board-to-board connector 634 arranged on the second PCB 616. The first cold plate 608 includes a first opening 636 and the second cold plate 614 includes a second opening 638. The first opening 636 and the second opening 638 allow the male board-to-board connector 632 and the female board-to-board connector 634 to connect to each other through the first cold plate 608 and the second cold plate 614. The male board-to-board connector 632 and the female board-to-board connector 634 provide electrical connections between the first PCB 610 and the second PCB 616, allowing power and/or communication therebetween. The male and female board-to-board connectors 632 and 634 and/or the first and second ports 624 and 626 can be arranged to be self-aligning to aid in coupling the first electronics module 602 and the second electronics module 604. In some embodiments, the alignment of the male and female board-to-board connectors 632 and 634 and/or the first and second ports 624 and 626 can work together with the fasteners snapping in place to align the first electronics module 602 and the second electronics module 604.

Although two modules are shown in the modular processing system 600 of **FIG. 6A****,** this design can be modified to have one or more additional modules stacked in series. Ports (e.g., similar to the first port 624 and the second port 626) can be provided between cold plates of each adjacent module, allowing the coolant to flow through all of the cold plates in the stack in series. Accordingly, a single inlet 620 and a single outlet 622 can be used to provide coolant to the cold plates of the entire stack.

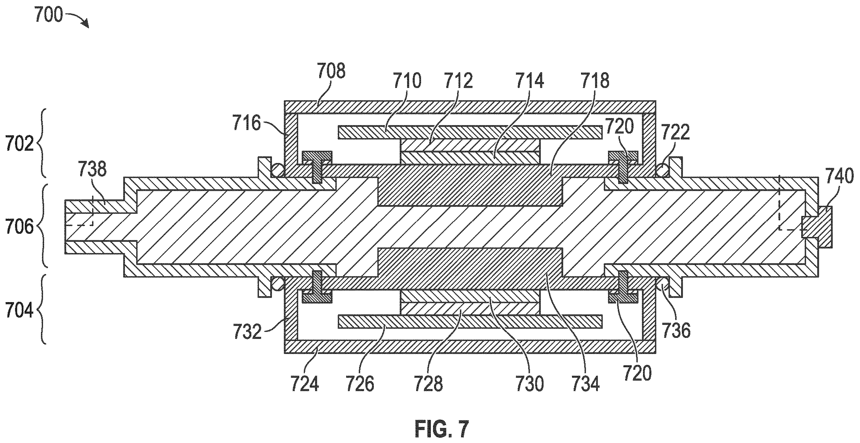

**FIG. 7** provides a cross-sectional view of yet another modular processing system 700 in accordance with aspects of this disclosure. As shown in **FIG. 7****,** the modular processing system 700 includes a first electronics module 702, a second electronics module 704, and a cold plate frame 706.

The first electronics module 702 includes a first cover 708, a first PCB 710, a first processor 712 arranged on the first PCB 710, a first curable TIM 714, and a first enclosure 716. The first enclosure 716 together with the first cover 708 are configured to enclose the first PCB 710. The first enclosure 716 includes one or more pedestals and a plurality of fins 718. The fins 718 are configured to increase heat transfer from the first processor 712 into the coolant. The first processor 712 is thermally coupled to the first enclosure 716 via the first curable TIM 714. In some embodiments, the first processor 712, the first curable TIM 714, and the plurality of fins 718 are vertically aligned (e.g., vertically overlap) to increase the heat transfer to the coolant. The first electronics module 702 is configured to be removably attached to the cold plate frame 706 via one or more fasteners 720. A first O-ring 722 can be used to seal the first electronics module 702 to the cold plate frame 706.

The second electronics module 704 includes a second cover 724, a second PCB 726, a second processor 728 arranged on the second PCB 726, a second curable TIM 730, and a second enclosure 732. The second enclosure 732 together with the second cover 724 are configured to enclose the second PCB 726. The second enclosure 732 includes one or more pedestals and a plurality of fins 734. The fins 734 are configured to increase heat transfer from the second processor 728 into the coolant. The second processor 728 is thermally coupled to the second enclosure 732 via the second curable TIM 730. In some embodiments, the second processor 728, the second curable TIM 730, and the plurality of fins 734 are vertically aligned (e.g., vertically overlap) to increase the heat transfer to the coolant. The second electronics module 704 is configured to be removably attached to the cold plate frame 706 via one or more fasteners 720. A second O-ring 736 can be used to seal the second electronics module 704 to the cold plate frame 706.

The cold plate frame 706 is configured to provide a coolant path that enables the coolant to flow through and remove heat from the cold plate frame 706. Thermal paths between components formed on the first electronics module 702 and the second electronics module 704 enable the cold plate frame 706 to cool the first electronics module 702 and the second electronics module 704. The coolant path is formed between the cold plate frame 706, the first enclosure 716 of the first electronics module 702, and the second enclosure 732 of the second electronics module 704. The cold plate frame 706 includes an inlet 738 and an outlet (obscured behind the inlet 738 in **FIG. 7****)** configured to receive the coolant from and return the coolant to a heat exchanger. A coolant plug 740 can be provided in one end of the cold plate frame 706, which can be used to drain the coolant during service of the modular processing system 700.

Each of the first electronics module 702 and the second electronics module 704 can be removably secured to the cold plate frame 706, enabling any one or more of the first electronics module 702, the second electronics module 704, and the cold plate frame 706 to be replaced at a service center. Since draining of coolant is a typical task performed at service centers, the service of the modular processing system 700 can be performed by service technicians without specialized equipment typically exclusive to manufacturing.

Because each of the first electronics module 702 and the second electronics module 704 is directly coupled to the single cold plate frame 706, the embodiment of **FIG. 7** may provide substantially the same level of cooling as the processing system 100 of **FIGs. 1A** and **1B****.**

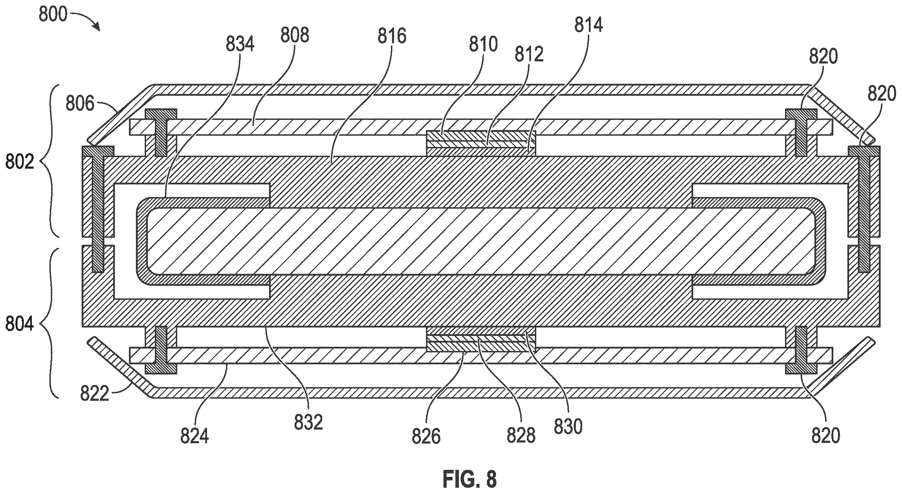

**FIG. 8** provides a cross-sectional view of still yet another modular processing system 800 in accordance with aspects of this disclosure. As shown in **FIG. 8****,** the modular processing system 800 includes a first electronics module 802 and a second electronics module 804.

The first electronics module 802 includes a first cover 806, a first PCB 808, a first processor 810, a first curable TIM 812, a first pedestal 814, and a first frame 816. The second electronics module 804 includes a second cover 806, a second PCB 824, a second processor 826, a second curable TIM 828, a second pedestal 830 , and a second frame 832. A plurality of fasteners 820 can be used to fasten the first PCB 808 to the first frame 816, the second PCB 824 to the second frame 832, and the first frame 816 to the second frame 832.

The first frame 816 and the second frame 832 are configured as a split frame that form a coolant path when coupled together. The first frame 816 and the second frame 832 can enclose a coolant channel 834 defining the coolant path. The modular processing system 800 enables the coolant to have direct contact with the first frame 816 and the second frame 832, providing increased levels of cooling.

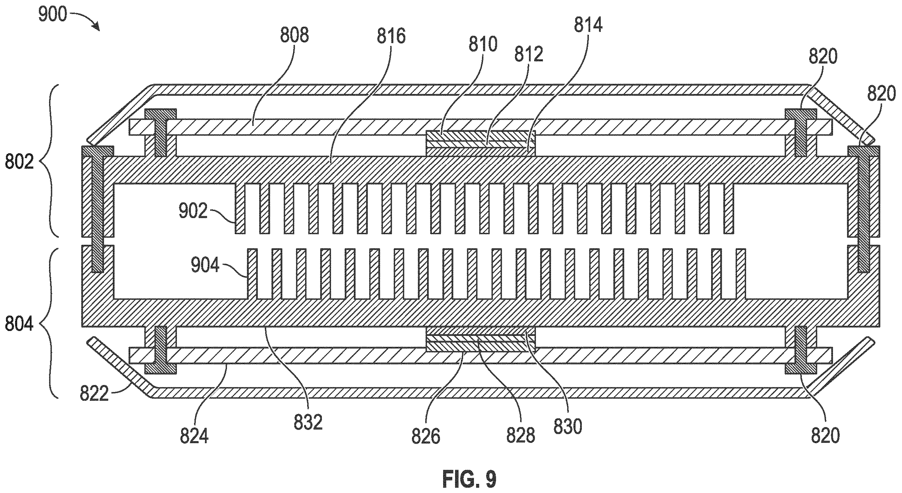

**FIG. 9** provides a cross-sectional view of an alternative embodiment of a modular processing system 900 compared to the modular processing system 800 of **FIG. 8****.** The modular processing system 900 may have certain similar components to the modular processing system 800 of **FIG. 8****,** and thus, the description of these components may also apply to the modular processing system 900 of **FIG. 9****.**

As shown in **FIG. 9****,** the first frame 816 includes a plurality of first fins 902 and the second frame 832 includes a plurality of second fins 904. The first frame 816 and the second frame 832 can form a cold plate when assembled. Because a separate cold plate is not included in this embodiment, a part can be eliminated from the modular processing system 900, reducing manufacturing costs.

In the embodiments of **FIGs. 8** and **9****,** the mounting of the first PCB 808 and the second PCB 824 onto the first frame 816 and the second frame 832 combined with the use of the first pedestal 814 and the second pedestal 830 can contribute to controlling the z-heights and flatness.

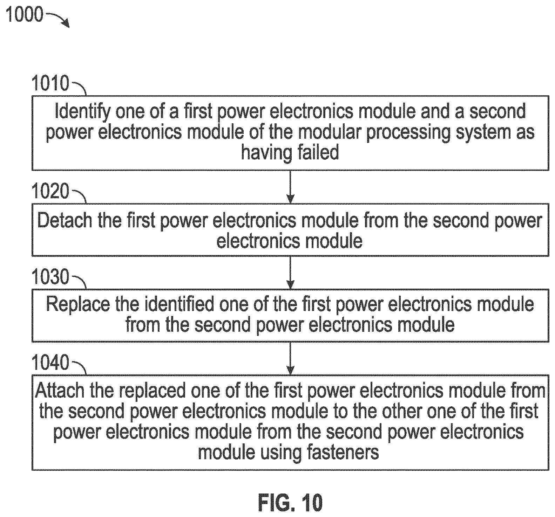

**FIG. 10** illustrates a method 1000 of replacing a module of a modular processing system in accordance with aspects of this disclosure. At block 1010, the method 1000 involves identifying one of a first electronics module and a second electronics module of the modular processing system as having failed. The first electronics module includes a first printed circuit board (PCB) and the second electronics module includes a second PCB. The first electronics module is secured to the second electronics module. The modular processing system further includes a first cold plate configured to cool the first PCB and the second PCB.

At block 1020, the method 1000 involves detaching the first electronics module from the second electronics module.

At block 1030, the method 1000 involves replacing the identified one of the first electronics module from the second electronics module.

At block 1040, the method 1000 involves attaching the replaced one of the first electronics module from the second electronics module to the other one of the first electronics module from the second electronics module using fasteners.

In some embodiments, the first cold plate is arranged between the first electronics module and the second electronics module. The first cold plate can be included in the first electronics module and/or the second electronics module.

In some embodiments, the method also includes applying one or more gap pads to an interposer of the second electronics module prior to attaching the replaced one of the first electronics module from the second electronics module to the other one of the first electronics module from the second electronics module using fasteners. In some embodiments, the method can also include removing residue from a gap pad of the replaced one of the first electronics module from the second electronics module using an alcohol wipe.

In some embodiments, attaching the replaced one of the first electronics module from the second electronics module to the other one of the first electronics module from the second electronics module using fasteners comprises clamping an interposer of the second electronics to the first cold plate with a pressure above a threshold pressure.

In some embodiments, the modular processing system further includes a second cold plate. The first cold plate can be included in the first electronics module and the second cold plate is included in the second electronics module. Attaching the replaced one of the first electronics module from the second electronics module to the other one of the first electronics module from the second electronics module using fasteners can include mounting the first electronics module to the second electronics module.

In some embodiments, the first cold plate includes a first port and the second cold plate includes a second port. The first port can be configured to be connected to the second port to form a connection that provides a coolant path for the coolant to flow from the first cold plate to the second cold plate. Mounting the first electronics module to the second electronics module can form a seal between the first port and the second port.

In some embodiments, the method further includes coupling a male board-to-board connector of the first PCB to a female board-to-board connector of the second PCB to provide an electrical connection between the first PCB and the second PCB.

### Conclusion

The foregoing disclosure is not intended to limit the present disclosure to the precise forms or particular fields of use disclosed. As such, it is contemplated that various alternate embodiments and/or modifications to the present disclosure, whether explicitly described or implied herein, are possible in light of the disclosure. Having thus described embodiments of the present disclosure, a person of ordinary skill in the art will recognize that changes may be made in form and detail without departing from the scope of the present disclosure. Thus, the present disclosure is limited only by the claims.

In the foregoing specification, the disclosure has been described with reference to specific embodiments. However, as one skilled in the art will appreciate, various embodiments disclosed herein can be modified or otherwise implemented in various other ways without departing from the spirit and scope of the disclosure. Accordingly, this description is to be considered as illustrative and is for the purpose of teaching those skilled in the art the manner of making and using various embodiments of the disclosed air vent assembly. It is to be understood that the forms of disclosure herein shown and described are to be taken as representative embodiments. Equivalent elements, materials, processes or steps may be substituted for those representatively illustrated and described herein. Moreover, certain features of the disclosure may be utilized independently of the use of other features, all as would be apparent to one skilled in the art after having the benefit of this description of the disclosure. Expressions such as "including", "comprising", "incorporating", "consisting of", "have", "is" used to describe and claim the present disclosure are intended to be construed in a non-exclusive manner, namely allowing for items, components or elements not explicitly described also to be present. Reference to the singular is also to be construed to relate to the plural.

Further, various embodiments disclosed herein are to be taken in the illustrative and explanatory sense, and should in no way be construed as limiting of the present disclosure. All joinder references (e.g., attached, affixed, coupled, connected, and the like) are only used to aid the reader's understanding of the present disclosure, and may not create limitations, particularly as to the position, orientation, or use of the systems and/or methods disclosed herein. Therefore, joinder references, if any, are to be construed broadly. Moreover, such joinder references do not necessarily infer that two elements are directly connected to each other. Additionally, all numerical terms, such as, but not limited to, "first", "second", "third", "primary", "secondary", "main" or any other ordinary and/or numerical terms, should also be taken only as identifiers, to assist the reader's understanding of the various elements, embodiments, variations and/or modifications of the present disclosure, and may not create any limitations, particularly as to the order, or preference, of any element, embodiment, variation and/or modification relative to, or over, another element, embodiment, variation and/or modification.

It will also be appreciated that one or more of the elements depicted in the drawings/figures can also be implemented in a more separated or integrated manner, or even removed or rendered as inoperable in certain cases, as is useful in accordance with a particular application.

## Claims

1. A modular processing system comprising:
a first electronics module comprising a first printed circuit board (PCB) and a first electronic component on the first PCB;
a second electronics module comprising a second PCB and a second electronic component on the second PCB; and
a cold plate arranged between the first electronics module and the second electronics module, the cold plate configured to circulate a coolant to cool the first PCB and the second PCB,
wherein at least a portion of the cold plate is included in the first electronics module, and
wherein the first electronics module is removably secured to the second electronics module.

2. The modular processing system of Claim 1, wherein:
the cold plate is attached to the first PCB with one or more thermal interface materials (TIMs) to form a thermal path between the cold plate and the first electronic component on the first PCB, and
the second electronics module further comprises an interposer attached to the second PCB and wherein the interposer is thermally coupled to the first cold plate.

3. The modular processing system of Claim 2, wherein:
the interposer is in direct contact with the cold plate, and the interposer is clamped to the cold plate; and/or
the interposer defines a cutout, and a thermal path between the second electronic component on the second PCB and the cold plate via the cutout.

4. The modular processing system of Claim 2 or 3, wherein the interposer is coupled to the cold plate via one or more gap pads, and wherein the modular processing system further comprises:
a heat spreader thermally coupled to the interposer, the heat spreader having a higher thermal conductivity than the interposer and configured to transfer heat from the second electronics component on the second PCB to the one or more gap pads.

5. The modular processing system of any one of the preceding Claims, further comprising:
one or more thermal gap pads coupling the second electronics module to the cold plate, the one or more thermal gap pads configured to provide a thermal interface between the second electronic component on the second PCB and the cold plate.

6. The modular processing system of any one of the preceding Claims, further comprising:
a second cold plate,
wherein the first electronics module includes the cold plate and the second electronics module includes the second cold plate.

7. The modular processing system of Claim 6, wherein the cold plate includes a first port and the second cold plate includes a second port, the first port is configured to be connected to the second port to provide a coolant path for the coolant to flow from the cold plate to the second cold plate.

8. The modular processing system of Claim 6 or 7, wherein:
the cold plate includes a first opening and the second cold plate includes a second opening,
the first PCB includes a male board-to-board connector and the second PCB includes a female board-to-board connector, and
the male board-to-board connector and the female board-to-board connector are configured to provide an electrical connection between the first PCB and the second PCB.

9. The modular processing system of any one of the preceding claims, wherein:
the first electronics module and the second electronics module are directly coupled to the cold plate; and/or
the cold plate comprises a first frame and a second frame configured to be attached to each other to form a coolant path through which the coolant flows.

10. The modular processing system of any one of the preceding claims, wherein the first electronic component on the first PCB comprises a system on a chip configured to execute at least a part of computations associated with autonomous vehicle functionality, and wherein the second electronic component on the second PCB is configured to execute at least a part of computations associated with infotainment.

11. A method of replacing a module of a modular processing system, the method comprising:
detaching a first electronics module from a second electronics module, wherein the first electronics module comprises a first printed circuit board (PCB) and the second electronics module comprises a second PCB, wherein the first electronics module is secured to the second electronics module prior to said detaching, and wherein the modular processing system comprises a cold plate configured to cool the first PCB and the second PCB; and
attaching a new first electronics module to the second electronics module using one or more fasteners.

12. The method of Claim 11, further comprising:
identifying that the first electronics module has failed prior to the attaching; and/or
removing the modulator processing system from a vehicle prior to said detaching; and/or
applying one or more gap pads to an interposer of the modulator processing system prior to said attaching.

13. The method of Claim 11 or 12, wherein:
the modulator processing system is installed in a vehicle prior to said detaching; and/or
the cold plate is arranged between the first electronics module and the second electronics module.

14. The method of any one of Claims 11 to 13, wherein:
the modular processing system further includes a second cold plate,
the cold plate is included in the first electronics module and the second cold plate is included in the second electronics module, and
said attaching comprises mounting the first electronics module to the second electronics module.

15. A modular processing system comprising:
a first electronics module comprising a first PCB and a first electronic component on the first PCB;
a second electronics module comprising a second PCB and a second electronic component on the second PCB; and
a cold plate configured to circulate a coolant to cool the first PCB and the second PCB,
wherein the cold plate comprises a portion of the first electronics module and a portion of the second electronics module, and
wherein the first electronics module is removably attached to at least one of the second electronics module or the cold plate by one or more fasteners.
